# EUROPÄISCHE PATENTANMELDUNG

(11) **EP 4 439 638 A2**
(43) Veröffentlichungstag der Anmeldung: **02.10.2024**
(21) Anmeldenummer: 24193780.4
(22) Anmeldetag: 29.06.2020
(51) Int. Cl.: H01L 21/687

(54) **SUBSTRATHALTER UND VERFAHREN ZUM FIXIEREN UND BONDEN EINES SUBSTRATS**

(62) Teilanmeldung aus: 20735549.6
(71) Anmelder: EV Group E. Thallner GmbH, 4782 St. Florian am Inn (AT)
(72) Erfinder: Plach, Thomas, 4782 St. Florian am Inn (AT)
(74) Vertreter: Schneider, Sascha

(57) **Zusammenfassung**

Die vorliegende Erfindung betrifft einen Substrathalter (1, 1', 1", 1‴, 1ʺʺ, 1‴ʺ) zur Aufnahme eines Substrats (13), aufweisend Fixierelemente (6,6`,6") zur Fixierung des Substrats (13), wobei die Fixierelemente (6,6`,6") in Zonen (7, 7') gruppierbar sind, sowie ein korrespondierendes Verfahren.

## Beschreibung

Die Erfindung beschreibt einen Substrathalter und ein Verfahren zum Fixieren und Bonden eines Substrats.

Im Stand der Technik existieren Druckschriften, in denen offenbart wird, wie man Substrate optimal miteinander verbinden kann. Insbesondere zeigt die Druckschrift WO2017162272A1 einen Substrathalter auf, der über einzelne Zonen verfügt. Zudem seien die Druckschriften WO2013023708A1, WO2012083978A1, WO2018028801A1 erwähnt.

Ein sehr großes Problem im Stand der Technik stellen asymmetrisch verformte Substrate dar. Viele Substrate besitzen eine mechanische Anisotropie, d.h. ihr E-Modul ist stark richtungsabhängig. Durch die Richtungsabhängigkeit des E-Moduls sind auch andere mechanischen Eigenschaften, insbesondere die Dehnungen, richtungsabhängig. Wirkt nun eine Kraft, insbesondere die Gravitationskraft, auf diese Substrate, so entsteht eine asymmetrische Verformung. Diese asymmetrische Verformung ist noch während des Kontakts zwischen den beiden Substraten und/oder während des Bondvorgangs vorhanden und führt notwendigerweise zu einer asymmetrischen Ausbreitung der Bondwellenfront und damit zu einem unterwünschten run-out Effekt.

Seit mehreren Jahren werden in der Halbleiterindustrie Substrate durch sogenannte Bondprozesse miteinander verbunden. Vor der Verbindung müssen diese Substrate möglichst genau zueinander ausgerichtet werden, wobei mittlerweile Abweichungen im Nanometerbereich eine Rolle spielen. Die Ausrichtung der Substrate erfolgt dabei meistens über Ausrichtungsmarken. Neben den Ausrichtungsmarken befinden sich noch andere, insbesondere funktionale Elemente, auf den Substraten, die während des Bondprozesses ebenfalls zueinander ausgerichtet sein müssen. Diese Ausrichtungsgenauigkeit zwischen den einzelnen funktionalen Elementen wird für die gesamte Substratoberfläche verlangt. Es ist daher beispielsweise nicht auseichend, wenn die Ausrichtungsgenauigkeit im Zentrum der Substrate sehr gut ist, zum Rand hin aber abnimmt.

Im Stand der Technik existieren wie bereits zuvor erwähnt mehrere Verfahren und Anlagen, mit deren Hilfe versucht werden kann, einen Einfluss auf den Bondvorgang zu nehmen, wie beispielsweise die Druckschriften WO2017162272A1, EP2656378B1 oder WO2014191033A1.

Eine der größten Herausforderungen beim Bonden ist die Zeitspanne, in der sich die beiden Substrate selbstständig miteinander verbinden. Das ist die Zeitspanne von der Bondinitiierung bis zur vollständigen Kontaktierung der Kontaktflächen der Substrate. Hierbei kann sich die Ausrichtung der beiden Substrate zueinander gegenüber der vorherigen Ausrichtung noch maßgeblich ändern. Sind die beiden Substratoberflächen erst einmal miteinander verbunden, ist eine Trennung zwar theoretisch wieder möglich, allerdings mit hohen Kosten, geringem Durchsatz und Fehleranfälligkeit verbunden.

Aufgabe der vorliegenden Erfindung ist es, eine Vorrichtung und ein Verfahren zum Bonden zweier Substrate vorzusehen, mit welchen die Probleme des Stands der Technik beseitigt werden und insbesondere die Bondgenauigkeit, insbesondere am Rand der Substrate, erhöht wird.

Die vorliegende Aufgabe wird mit den Merkmalen der nebengeordneten Ansprüche gelöst. Vorteilhafte Weiterbildungen der Erfindung sind in den Unteransprüchen angegeben. In den Rahmen der Erfindung fallen auch sämtliche Kombinationen aus zumindest zwei in der Beschreibung, in den Ansprüchen und/oder den Zeichnungen angegebenen Merkmalen. Bei angegebenen Wertebereichen sollen auch innerhalb der genannten Grenzen liegende Werte als Grenzwerte offenbart gelten und in beliebiger Kombination beanspruchbar sein.

Die Erfindung betrifft einen Substrathalter zur Aufnahme eines Substrats, aufweisend Fixierelemente zur Fixierung des Substrats, wobei die Fixierelemente in Zonen gruppierbar sind, wobei die Zonen vorzugsweise ringförmig noch bevorzugter kreisringförmig, angeordnet sind.

Eine Zone ist dabei eine beliebige Menge von Fixierelementen, unabhängig davon, ob sich die Fixierelemente örtlich benachbart oder auf gegenüberliegenden Randbereichen befinden. Da eine Zone eine Menge von Fixierelementen darstellt, kann sich die Definition oder Festlegung einer Zone auch mit der Zeit ändern.

Im weiteren Verlauf der Druckschrift wird von der Form oder der Position der Zone gesprochen. Gemeint sind damit die Form und die Positionen der Umhüllenden aller Fixierelemente innerhalb einer solchen Zone. Wenn von der Schaltfähigkeit einer Zone gesprochen wird, ist damit die Schaltfähigkeit aller Fixierelemente innerhalb der Zone gemeint. Insbesondere bedeutet das Ausschalten einer Zone das Ausschalten aller Fixierelemente innerhalb der Zone. Davon unberührt können vorzugsweise alle Fixierelemente innerhalb einer Zone ebenfalls einzeln geschaltet werden. Im Extremfall enthält eine Zone nur ein Fixierelement.

Vorzugsweise können alle Fixierelemente derselben Zone durch ein einzelnes Steuerelement, insbesondere ein Steuerventil bei der Verwendung von Vakuumfixierelementen, angesteuert werden. Dadurch ist es vorteilhaft möglich, alle Fixierelemente einer Zone gleichzeitig zu schalten.

Die unterschiedlichen Fixierelemente bzw. Zonen können insbesondere zeitversetzt geschaltet werden, um vorteilhaft die voranschreitende Bondwelle zielgerichtet zu verformen.

Die Erfindung betrifft weiterhin ein Verfahren zur Fixierung und zum Bonden eines Substrats oder mehrerer Substrate, insbesondere mit einem erfindungsgemäßen Substrathalter, wobei Fixierelemente in Zonen gruppiert werden, wobei die Zonen vorzugsweise ringförmig, noch bevorzugter kreisringförmig, ausgebildet werden.

Durch die ringförmige Anordnung kann vorteilhaft das Substrat bei einem Bondvorgang optimal fixiert und losgelöst werden, sodass insbesondere der "run-out"-Fehler minimiert und dadurch die Bondgenauigkeit wesentlich erhöht werden kann. Bei bevorzugter kreisringförmiger Anordnung ist die Fixierung und Loslösung noch besser möglich, da sich zumeist die Bondwelle ebenfalls kreisringförmig ausbreitet.

Bevorzugt ist ein Substrathalter vorgesehen, wobei die Zonen symmetrisch zum Zentrum des Substrathalters angeordnet sind. Da sich die Bondwelle zumeist symmetrisch zum Zentrum des Substrathalters ausbreitet, wird hierdurch vorteilhaft eine weitere Verbesserung der Bondgenauigkeit erreicht.

Bevorzugt ist weiterhin ein Substrathalter vorgesehen, wobei die Zonen in mehreren Ringen, bevorzugt Kreisringen, um das Zentrum des Substrathalters herum angeordnet sind. So kann vorteilhaft auch in radialer Richtung des Substrathalters eine optimale Loslösung erfolgen.

Bevorzugt ist weiterhin ein Substrathalter vorgesehen, wobei die Zonen in radialer Richtung und/oder in azimutaler Richtung gleichmäßig voneinander beabstandet sind. Hierdurch kann vorteilhaft eine besonders exakte Steuerung der Loslösung erfolgen.

Bevorzugt ist weiterhin ein Substrathalter vorgesehen, wobei die Zonen vom Zentrum des Substrathalters zum Rand des Substrathalters hin mit sich ändernder Breite, insbesondere mit größer werdender Breite, ausgebildet sind. Diese sich ändernde Breite kann notwendig sein um, ein besseres Bondergebnis zu erzielen, da sich auch die Geschwindigkeit, mit der sich eine Bondwelle ausbreitet, als Funktion des Abstandes vom Zentrum hin ändern kann.

Bevorzugt ist weiterhin ein Substrathalter vorgesehen, wobei die Zonen einzeln schaltbar sind. So ist vorteilhaft eine flexible Steuerung der Zonen je nach gewünschter Ablösung möglich.

Bevorzugt ist weiterhin ein Substrathalter vorgesehen, wobei mehrere Zonen gruppierbar und gemeinsam schaltbar sind. So kann vorteilhaft je nach Bedarf eine größere Fläche geschaltet werden, sodass die Ablösung noch flexibler und exakter möglich ist.

Bevorzugt ist weiterhin ein Substrathalter vorgesehen, wobei die Anzahl der Fixierelemente in den Zonen flexibel veränderbar ist. So kann z.B. die Anziehungskraft in den einzelnen Zonen erhöht oder verringert werden, sodass vorteilhaft eine exakte Steuerung der Ablösung möglich ist.

Bevorzugt ist weiterhin ein Substrathalter vorgesehen, wobei die Fixierelemente flexibel verschiedenen Zonen zugeordnet werden können. Zudem ist es alternativ oder zusätzlich möglich, dass die Fixierelemente zonenübergreifend ansteuerbar sind. So kann vorteilhaft die Haltekraft in den Zonen flexibel je nach Bedarf eingestellt werden.

Die Erfindung beschreibt insbesondere eine Vorrichtung und ein Verfahren um einen Bond zwischen zwei Substraten mit minimalem run-out zu erzeugen. Der Erfindung liegt dabei insbesondere der Gedanke zu Grunde, mindestens einen Substrathalter zu verwenden, der über speziell geformte Zonen, bestehend aus mehreren Fixierelemente, zur Fixierung eines, insbesondere asymmetrisch verformten, Substrats verfügt. Durch die speziell geformten Zonen und deren Fixierelementen, insbesondere auch durch eine erfindungsgemäße Schaltung dieser Zonen bzw. deren Fixierelementen, wird die asymmetrische Verformung der Substrate, insbesondere auch noch während des Bondvorgangs, so kompensiert, dass sich eine optimale Bondwellenfront und damit ein optimaler Bond ergibt.

Im Allgemeinen weiß man nicht, welche Substrate als nächstes auf einem Substrathalter fixiert werden, welche mechanische Anisotropie sie besitzen oder wie stark sie sich bei einer Fixierung verzerren. Des Weiteren werden Substrate, die unterschiedliche Dicken aufweisen, im Allgemeinen durch die Gravitation auch unterschiedlich stark verformt, wenn sie an einem oberen Substrathalter fixiert werden. Daher ist es nicht möglich, für jede Art von auftretender Asymmetrie einen neuen Substrathalter zu erzeugen.

Durch den erfindungsgemäßen Substrathalter werden vorteilhaft insbesondere die asymmetrisch verformten Substrate mittels gezielter Schalttechniken der Zonen so kompensiert, dass die Asymmetrien, insbesondere noch während des Bondvorgangs, kompensiert werden können. Man muss daher vorteilhafterweise nur eine Art von Substrathalter konstruieren und kann diesen für unterschiedliche Substrate mit unterschiedlich starken asymmetrischen Verformungen verwenden.

Der Erfindung liegt der Gedanke zugrunde, einen Substrathalter mit speziell geformten Zonen zu versehen, deren Form, Anordnung und Ansteuerung das Bondergebnis verbessert. Wie bereits in der Druckschrift WO2017162272A1 ausführlich beschrieben wurde, ist die Einstellung der Krümmung eines Substrats von entscheidender Bedeutung für den erfolgreichen, fehlerfreien Bondvorgang. Die vorliegende Erfindung beschreibt daher vor allem sehr spezielle Substrathalter, deren Entwicklung in den letzten paar Monaten und Jahren abgeschlossen wurde. Insbesondere wird auch auf die bereits veröffentlichten Verfahrensschritte aus der WO2017162272A1 verwiesen.

Der erfindungsgemäße Substrathalter wird hauptsächlich als oberer Substrathalter verwendet, kann aber durchaus auch an der Unterseite einer Bondanlage für die Fixierung unterer Substrate verwendet werden. Insbesondere kann jeweils ein erfindungsgemäßer Substrathalter als oberer und ein erfindungsgemäßer Substrathalter als untere Substrathalter verwendet werden. Die gezielte Einstellung der Krümmung, die in der WO2017162272A1 ausführlich behandelt und offenbart wurde, wird durch die erfindungsgemäße Konstruktion des neuen Substrathalters weiter verbessert.

Mit Krümmungsänderung ist insbesondere ein von einem Ausgangszustand (insbesondere die vor dem Kontaktieren eingestellte Krümmung) der Substrate abweichender Zustand gemeint. Erfindungsgemäß wird das Bonden nach einer Kontaktierung der Kontaktflächen, insbesondere durch kontrollierte Steuerung einer Fixierung der Substrate, gesteuert. Entsprechende Fixiermittel sind vorrichtungsgemäß insbesondere vorgesehen.

Ein weiterer, insbesondere eigenständiger, Aspekt der vorliegenden Erfindung besteht in der Anwendung von, insbesondere einzeln schaltbaren Fixierelementen, die in besonders geformten Zonen gruppiert werden und mit deren Hilfe eine sich fortschreitende Bondwelle zwischen den Kontaktflächen kontrolliert gesteuert oder geregelt werden kann. Die Form der offenbarten Zonen ist so speziell, dass ein wichtiges Unterscheidungsmerkmal zur Druckschrift WO2017162272A1 gegeben ist.

Eine Zone verfügt im Allgemeinen über mindestens ein Fixierelement, im Speziellen allerdings über mehrere Fixierelemente, die einzeln angesteuert werden können.

Der Idee liegt dabei vor allem der Gedanke zu Grunde, durch eine gezielte Kontrolle, Steuerung oder Regelung der Krümmung und/oder Fixierung und/oder Loslösung mindestens eines der beiden Substrate die fortschreitende Bondwelle so zu kontrollieren, zu steuern oder regeln, dass eine optimale, sequentielle, insbesondere von innen nach außen fortschreitende, Kontaktierung der beiden Substrate entlang der Kontaktflächen erfolgt. Durch dieses erfindungsgemäße Verfahren sollen, insbesondere mechanische, Asymmetrien des Substrats, die vor und/oder während des Bondens vorhanden sind, so kompensiert werden, dass die Bondwelle eine gewünschte, insbesondere eine radialsymmetrische, Form besitzt. Erfindungsgemäß wird dieser Effekt durch speziell geformte Zonen und eine erfindungsgemäße Ansteuerung der Fixierelemente der Zonen erzielt. Unter optimaler Kontaktierung versteht man insbesondere, dass der "run-out" Fehler an jeder Stelle der Kontaktgrenzfläche zwischen den beiden Substraten, minimal ist oder im optimalen Fall sogar verschwindet.

Im Allgemeinen erlaubt der erfindungsgemäße Substrathalter das Fortschreiten der Bondwelle richtungsabhängig zu beeinflussen. Insbesondere kann mit dem erfindungsgemäßen Substrathalter eine Bondwellenfront erzeugt werden, die sich radialsymmetrisch, d.h. kreisrund ausbreitet. Das vom erfindungsgemäßen Substrathalter gehaltene Substrat kann durch die Ansteuerung der einzelnen speziell geformten Zonen daher gezielt anisotrop verformt werden.

Abhängig davon, ob der erfindungsgemäße Substrathalter an der ober oder an der Unterseite verwendet wird, entsteht ein anderer Einfluss auf die von ihnen fixierten Substrate. Der größte Unterschied zwischen den beiden Substraten ist die Richtung der Wirkung der Gravitation während des Bondprozesses. Die Gravitation bewirkt beim oberen fixierten Substrat nach der Aktivierung und/oder Deaktivierung zumindest einiger Zonen einen, im Allgemeinen anisotropen, Durchhang. Beim unteren Substrat ist dies nicht der Fall.

### Sensoren

Vorzugsweise werden in den erfindungsgemäßen Substrathalter Sensoren zur Überwachung des Abstandes zwischen Substrat und Substrathalter eingebaut. Mit Hilfe der Sensoren können auch die Ausbreitungsgeschwindigkeit und die, insbesondere symmetrische, Form der Bondwelle während des Bondprozesses überwacht und, falls notwendig, adaptiv angepasst werden. Werden diese erfindungsgemäßen Erweiterung in beiden Substrathaltern eingebaut, können damit gleichzeitig beide Substrate vermessen und, insbesondere noch während des Bondvorgangs, so angepasst werden, dass ihr run-out Fehler minimiert wird. Die Anpassung erfolgt dabei insbesondere durch die gezielte Schaltung der unterschiedlichen, speziell geformten Zonen.

### Fixierelemente

Alle erfindungsgemäß genannten Fixierelemente können einzeln, d.h. in den fixierenden oder nicht fixierenden Zustand, geschalten werden. Insbesondere ist auch die Anpresskraft des Substrats auf die Fixierelemente gezielt einstellbar, sodass die Normalkraft bzw. Normalspannung bestimmt werden kann.

Die Fixierelemente können durch Dichtelemente voneinander getrennt sein. In einer besonders bevorzugten erfindungsgemäßen Ausführungsform sind die Fixierelemente allerdings in Bezug auf die Substrathalteroberfläche zurückgesetzt, insbesondere gefräst. Diese Ausführungsform eignet sich vor allem bei der Verwendung von Vakuumfixierelementen. In einer erfindungsgemäßen Erweiterung befinden sich kleine Erhöhungen, Stifte, Pins oder Stege in der Vertiefung, deren Oberfläche kongruent zur Substrathalteroberfläche ist.

Die einzelnen Fixierelemente innerhalb einer Zone (beispielsweise Kreissegmente auf demselben Radius) sind flexible steuerbar, sodass es beispielsweise möglich ist das Substrat während dem Ladevorganz fast entlang des gesamten Umfangs zu fixieren. Dadurch ist das Substrat zu diesem Zeitpunkt möglichst flach. Für den Bondprozess selbst ist es dann möglich mehrere Fixierelemente entlang desselben Radius zu deaktivieren.

Auch ist es möglich die Fixierungseigenschaft der Fixierelemente einer Zone entweder zeitgleich, oder auch mit definierter Verzögerung abzuschalten, was eine feinere Kontrolle der Bondgeschwindigkeit ermöglicht. Insbesondere wenn man ein nicht radialsymmetrisches Fortschreiten der Bondwellenfront misst, können die einzelnen Fixierelemente so geschaltet werden, dass die Bondwellenfront wieder radialsymmetrisch wird.

Sind die Fixierelemente als Vakuumfixierelemente ausgelegt, so liegt in den Vakuumfixierungen ein Druck zwischen 0.01mbar und 1000mbar, vorzugsweise zwischen 0.01mbar und 800mbar, noch bevorzugter zwischen 0.01mbar und 500mbar, am bevorzugtesten zwischen 0.01mbar und 100mbar, am allerbevorzugtesten zwischen 0.01mbar und 10mbar an. Der Differenzdruck zwischen dem größeren, äußeren Druck dem kleineren, inneren Druck in den Vakuumfixierelementen ist dann der Anpressdruck auf das Substrat, welcher zur Fixierung des Substrats führt.

### Zonen

Die einzelnen Fixierelemente können zu Zonen gruppiert werden.

In einer ersten erfindungsgemäßen Ausführungsform befinden sich mehrere Zonen ausschließlich in der Peripherie des Substrathalters. Die Zonen sind dabei radial und/oder azimutal voneinander getrennt. Insbesondere existieren eine radiale und eine azimutale Teilung.

Die Zonen sind vorzugsweise symmetrisch um eine Drehachse mit n-zähliger Symmetrie angeordnet. Der Wert von n ist dabei größer als 1, vorzugsweise größer als 4, noch bevorzugter größer als 6, am bevorzugtesten größer als 12, am allerbevorzugteste größer als 24. Je größer die Zähligkeit der Drehachse, desto mehr Zonen existieren entlang eines Kreisumfangs, aber desto kleiner sind die Zonen entlang ihres azimutalen Winkels. Die optimale Anzahl der Zonen pro Kreisumfang, sowie die optimale Anzahl der Zonen entlang der radialen Richtungen werden insbesondere durch empirische Messungen und/oder durch Simulationen bestimmt.

In einer ersten erfindungsgemäßen Ausführungsform befinden sich mehrere Zonen, insbesondere bestehend aus mehreren Fixierelementen, in der Periphere des Substrathalters und eine große Zone, die insbesondere nur aus einem einzigen Fixierelement besteht, im Zentrum. Diese zentrische Zone nimmt den größten Teil der Substratoberfläche ein und dient einer starken Fixierung eines Substrats. Die Zonen an der Peripherie des Substrathalters dienen der feinen Steuerung, insbesondere der gezielten Beeinflussung der Bondwellenform.

In einer zweiten erfindungsgemäßen Ausführungsform besteht der Substrathalter ausschließlich aus, insbesondere in der Periphere angebrachten, Zonen, bestehend aus mehreren Fixierelementen. Der flächenmäßig größte Teil des Substrathalters verfügt über keine Zonen.

In einer dritten erfindungsgemäßen Ausführungsform besteht der Substrathalter ausschließlich aus, insbesondere in der Periphere angebrachten, Zonen, bestehend aus mehreren Fixierelementen sowie aus einer, insbesondere vollumfänglichen, geschlossenen, einzelnen Zone, bestehend aus mindestens, vorzugsweise genaue einem, Fixierelement.

In einer vierten erfindungsgemäßen Ausführungsform wird das Substrat am äußeren Rand durch eine vollumfängliche, insbesondere geschlossene, am bevorzugtesten ringförmig Zone bestehend aus mindestens einem Fixierelement fixiert. Zonen, die sich innerhalb der äußeren Zone befinden können so geschaltet werden, dass sie das Substrat verformen. Das ist insbesondere dann möglich, wenn die Fixierfunktion der einzelnen Fixierelemente auf einer Vakuumabsaugung bzw. einer Spülmöglichkeit eines Fluids beruht.

In einer fünften erfindungsgemäßen Ausführungsform sind zumindest einige der Zonen so geformt, dass sie andere Zonen umschließen oder zumindest umranden.

Die Zonen und/oder die Fixierelemente können insbesondere in folgenden Konfigurationen angeordnet werden:
1. Ringform
2. Spiralen
3. Rasterform
4. Radialstrahlen
5. Kombination der oben genannten (insbesondere, Ringe die durch Radialstrahlen verbunden sind)

### Ladestifte

Verfügt der Substrathalter über Ladestifte (engl.: loading pins) befinden sich notwendigerweise Löcher in der Substrathalteroberfläche. Werden die Zonen mittels Vakuumfixierungen geschalten, müssen möglichweise Vorkehrungen zur Dichtheit getroffen werden. Bedingt durch die Löcher in denen sich diese Ladestifte bewegen ergeben sich mehrere Varianten für das Anlegen des Überdrucks in den Zonen:
In einer ersten Variante bleiben die Löcher einfach offen (mit Optimierung der Ausführung für kleine Leckage) und der Überdruck muss durch entsprechenden kontinuierlichen Fluss eines Fluids in den Bereich zwischen Substrat und Substrathalterung aufrechterhalten werden (Gleichgewicht zwischen Zu- und Abfluss)

In einer zweiten Variante werden die Ladestifte mit einer Dichtung versehen, die es ermöglicht einen statischen Überdruck im abgeschlossenen Bereich zwischen Wafer und Haltevorrichtung aufzubauen.

Wird der erfindungsgemäße Substrathalter als oberer Substrathalter ausgeführt, kann es sich bei den Ladestiften um Stifte handeln, die in ihrem Inneren über eine Bohrung, einen Schlauch oder ein anderes Fluidsystem verfügen, mit der/dem ein Vakuum an der Ladestiftoberfläche erzeugt wird, sodass man ein zu ladendes Substrat gegen die Gravitationsrichtung fixieren und heben kann. Diese Ladestifte ziehen das fixierte Substrat also beim Ladevorgang nach oben, bis es mit der Substrathalteroberfläche kontaktiert und von dieser schließlich fixiert wird.

### Aussparungen

Der erfindungsgemäße Substrathalter verfügt insbesondere über Durchgänge bzw. Aussparungen, die insbesondere verglast sein können, um auf die Rückseite der fixierten Substrate blicken zu können. Die Durchgänge sind vorzugsweise mit Deckeln, insbesondere automatisch, verschließbar.

### Verformelement

Eine weitere, insbesondere eigenständige oder mit der vorgenannten Erfindung kombinierbare, Idee besteht in der Verwendung eines Verformelements als Krümmungsmittel und/oder Krümmungsänderungsmittel, das insbesondere als Gasaustrittsöffnung ausgebildet wird. Dadurch unterbleibt ein mechanischer Kontakt zum Substrat. Die Kontrolle der Krümmung erfolgt durch Kombination der vorgenannten Merkmale noch genauer.

Alle beschriebenen erfindungsgemäßen Ausführungsformen können über Verformelemente verfügen, welche das fixierte Substrat verformen. Insbesondere kann jede einzelne Zone, sofern sie über Vakuumfixierelemente verfügt, Fluide zur Verformung der Substrate verwenden.

Arbeitet das Verformelement mit einem Fluid, so liegt der Druck des Fluids zwischen 0.1bar und 10bar, vorzugsweise zwischen 0.2bar und 8bar, noch bevorzugter zwischen 0.3bar und 7bar, am bevorzugtesten zwischen 0.4bar und 6bar, am allerbevorzugtesten zwischen 0.5bar und 5bar.

Dir Kraft, mit der das Verformelement ein Substrat beaufschlagt liegt zwischen 0.1N und 1000N, vorzugsweise zwischen 0.2N und 500N, noch bevorzugter zwischen 0.3N und 250N, am bevorzugtesten zwischen 0.4N und 200N, am allerbevorzugtesten zwischen 0.5N und 100N.

### Überwachung der Bondwelle

Um die Ausbreitungsgeschwindigkeit der Bondwellenfront richtungsabhängig zu bestimmen können Sensoren in den Substrathalter integriert werden die es ermöglichen den Abstand zwischen der Substrathalteroberfläche und dem geladenen Substrat zu jedem beliebigen Zeitpunkt zu messen:
1. Mehrere Sensoren entlang des Radius um die Geschwindigkeit als Funktion des Abstandes zum Zentrum zu bestimmen, insbesondere entlang der Radien, die durch die Zentren der einzelnen Zonen verlaufen.
2. Mehrere Sensoren entlang der Radien, die zwischen den Radien die in Punkt 1 genannt werden liegen. Dadurch ist die Bestimmung der Geschwindigkeiten in unterschiedliche Richtungen möglich.

Durch die vorhandenen Sensoren, die den Abstand zwischen einem Substrat und der Substrathalteroberfläche bestimmen können ist es möglich die Ausbreitung der Bondwelle zu überwachen. Jeder Sensor hat vor dem Start des Bondprozesses einen gewissen Startwert. Der Startwert ist beispielsweise null wenn das Substrat im Bereich des Sensors in Kontakt mit der Substrathalteroberfläche ist. Der Startwert hat einen Wert größer null falls das Substrat nicht überall fixiert wird und beispielsweise lokal durchhängt oder lokal gekrümmt ist. Jeder Sensor erhält insbesondere einen Endwert nach Beendigung des Bondprozesses. Wenn sich nun der Wert des Sensors entsprechend ändert kann daraus geschlossen werden ob die Substrate im Bereich des jeweiligen Sensors gebondet wurden oder nicht. Dadurch ergibt sich ein Verlauf der Bondwellenposition als Funktion der Zeit. Abhängig von der genauen Anordnung der Sensoren ist es auch möglich Daten der Bondwellenposition als Funktion der Zeit in verschiedene Richtungen zu erfassen.

### Verfahren

### Bondmessungsverfahren

Ein bevorzugtes, **erstes** erfindungsgemäßes Verfahren, mit dessen Hilfe die Bondwellenfront zweier zu bondender Substrate vermessen und angepasst werden kann lautet wie folgt.

In einem **ersten** Verfahrensschritt wird ein erstes Substrat an einem ersten, insbesondere erfindungsgemäßen, Substrathalter fixiert.

In einem **zweiten** Verfahrensschritt wird ein zweites Substrat an einem zweiten, insbesondere erfindungsgemäßen, Substrathalter fixiert.

In einem **dritten** Verfahrensschritt werden die Werte der Sensoren, welche die Substratrückseiten des ersten und/oder des zweiten Substrats vermessen, ermittelt und/oder genullt. Insbesondere handelt es sich bei den Sensoren um Abstandssensoren.

In einem **vierten** erfindungsgemäßen Verfahrensschritt werden die beiden Substrate solange aneinander angenähert, bis ein gewünschter Abstand zwischen den Substratoberflächen, die miteinander verbondet werden sollen, vorhanden ist.

In einem **fünften** erfindungsgemäßen Verfahrensschritt werden das obere und/oder das untere Substrat, mit Hilfe eines bereits erwähnten Verformelements, verformt, sodass eine Kontaktierung der beiden Substrate an mindestens einem, insbesondere genau einem, Punkt erfolgt. Insbesondere erfolgt bereits bei der Verformung des oberen und/oder unteren Substrats die Vermessung der Substratoberflächenrückseiten mithilfe der Sensoren, sodass die Krümmungen des oberen und/oder unteren Substrats vor und/oder während der Kontaktierung bereits genauestens bekannt sind. Dadurch lässt sich bereits eine mögliche, auftretende Asymmetrie in der Durchbiegung erkennen.

In einem **sechsten** erfindungsgemäßen Verfahrensschritt erfolgt eine, insbesondere gezielt gesteuerte, durch die individuelle Schaltung der Fixierelemente der einzelnen Zonen bewirkte, Loslösung des ersten und/oder zweiten Substrats, genau so, dass sich die Bondwellenfront zeitlichen so entwickelt, wie gewünscht. Insbesondere soll die Bondwellenfront zwischen den beiden Substraten zu allen Zeitpunkten eine radialsymmetrische Form annehmen. Während der Ausbreitung der Bondwellenfront vermessen die Sensoren kontinuierlich die Substratoberflächenrückseiten des ersten und/oder zweiten Substrats, sodass bei einer ungewollten Abweichung der Bondwellenfront durch eine gezielte Ansteuerung der einzelnen Fixierelemente der Zonen die Bondwellenfront wieder in ihre gewünschte Form gebracht werden kann.

Ein alternatives, **zweites** bevorzugtes erfindungsgemäßes Verfahren führt den vierten und den fünften Verfahrensschritt des ersten erfindungsgemäßen Verfahrens in umgekehrter Reihenfolge aus. Das erste und/oder das zweite Substrat werden zuerst verformt, ohne sich miteinander zu berühren. Danach erfolgt eine relative Annäherung beider Substrate zueinander, bis der Kontakt erfolgt. Insbesondere endet die relative Annäherung der beiden Substrate durch die relative translatorische Bewegung der beiden Substrathalter sobald die Kontaktierung erfolgt ist.

In einer speziellen Ausführungsform des erfindungsgemäßen Verfahrens wird das untere Substrat immer vollflächig fixiert, daher nicht gekrümmt.

Neben den erfindungsgemäßen Verfahren der Bondwellenvermessung existieren noch die erfindungsgemäßen Verfahren der Bondwellenmanipulation. Diese können insbesondere mit den oben genannten Verfahren der Bondwellenvermessung kombiniert werden, insbesondere im Verfahrensschritt 6. Diese erfindungsgemäßen Verfahren sind sehr speziell und vor allem abhängig von erfindungsgemäßen Substrathaltern mit speziellen Zonen. Sie werden hier im Einzelnen beschrieben.

Das **erste** erfindungsgemäße Verfahren zur Bondwellenmanipulation besitzt insbesondere noch folgende Verfahrensschritte:

### Erstes Bondverfahren

In einem **ersten** erfindungsgemäßen Verfahrensschritt wird das untere Substrat vollflächig fixiert, d.h. nicht gekrümmt.

In einem **zweiten** erfindungsgemäßen Verfahrensschritt wird das obere Substrat an einem Substrathalter mit mehreren, insbesondere ausschließlich in der Peripherie des Substrathalters vorhandenen, Zonen fixiert. Vorzugsweise existieren so viele Zonen, dass man eine 2*n-zählige Symmetrie erzeugt werden kann. Besonders bevorzugt sind Substrathalter mit jeweils acht peripheren Zonen. Vier Zonen befinden sich dann beispielsweise bei 0°, 90°,180° und 270°, im Weiteren als Normalposition bezeichnet. Die restlichen vier, insbesondere längeren, Zonen befinden sich dazwischen, also auf 45°, 135°, 225° und 315°, im Weiteren als Diagonalposition bezeichnet. Anfangs sind alle 2n Zonen im schaltenden Zustand und fixieren das obere Substrat, sodass dieses stark fixiert wird und die Auswirkung der Durchbiegung durch die Gravitation zumindest minimiert wird.

In einem **dritten** erfindungsgemäßen Verfahrensschritt werden nun n der 2*n Zonen deaktiviert. Insbesondere werden die längeren Zonen an den Diagonalpositionen deaktiviert. Durch die Deaktivierung der n-Zonen wird das Substrat vorzugsweise so verformt, dass eine Asymmetrie aufgrund der mechanischen Anisotropie und der Gravitation dahingehend kompensiert wird, dass beim Bondvorgang die Bondwellenfront die gewünschte Form erhält, insbesondere radialsymmetrisch ist.

In einem **vierten** erfindungsgemäßen Verfahrensschritt erfolgt die Kontaktierung der Substrate, insbesondere mit Hilfe eines Verformungsmittels und/oder durch relative Annäherung der Substrathalter zueinander.

In einem **fünften** erfindungsgemäßen Verfahrensschritt erfolgt eine Vermessung der Substrathalterrückseiten des ersten und/oder zweiten Substrats und falls nötig eine entsprechende Anpassung der ausbreitenden Bondwellenfront durch entsprechende Schaltung der Fixierelemente der einzelnen Zonen.

### Zweites Bondverfahren

Das **zweite** erfindungsgemäße Verfahren zur Bondwellenmanipulation besitzt insbesondere noch folgende Verfahrensschritte:
In einem **ersten** erfindungsgemäßen Verfahrensschritt wird das untere Substrat an einem Substrathalter mit mehreren, insbesondere ausschließlich in der Peripherie des Substrathalters vorhandenen, Zonen fixiert. Vorzugsweise existieren so viele Zonen, dass man eine 2*n-zählige Symmetrie erzeugt werden kann. Besonders bevorzugt sind Substrathalter mit jeweils acht peripheren Zonen. Vier Zonen befinden sich dann beispielsweise bei 0°, 90°,180° und 270°, im Weiteren als Normalposition bezeichnet. Die restlichen vier, insbesondere längeren, Zonen befinden sich dazwischen, also auf 45°, 135°, 225° und 315°, im Weiteren als Diagonalposition bezeichnet. Anfangs sind alle 2n Zonen im schaltenden Zustand und fixieren das untere Substrat.

In einem **zweiten** erfindungsgemäßen Verfahrensschritt wird das obere Substrat an einem Substrathalter mit mehreren, insbesondere ausschließlich in der Peripherie des Substrathalters vorhandenen, Zonen fixiert. Vorzugsweise existieren so viele Zonen, dass man eine 2*n-zählige Symmetrie erzeugt werden kann. Besonders bevorzugt sind Substrathalter mit jeweils acht peripheren Zonen. Vier Zonen befinden sich dann beispielsweise bei 0°, 90°,180° und 270°, im Weiteren als Normalposition bezeichnet. Die restlichen vier, insbesondere längeren, Zonen befinden sich dazwischen, also auf 45°, 135°, 225° und 315°, im Weiteren als Diagonalposition bezeichnet. Anfangs sind alle 2n Zonen im schaltenden Zustand und fixieren das obere Substrat, sodass dieses stark fixiert wird und die Auswirkung der Durchbiegung durch die Gravitation zumindest minimiert wird.

In einem **dritten** erfindungsgemäßen Verfahrensschritt werden die Zonen an den Diagonalpositionen deaktiviert.

In einem **vierten** erfindungsgemäßen Verfahrensschritt erfolgt die Kontaktierung der Substrate, insbesondere mit Hilfe eines Verformungsmittels und/oder durch relative Annäherung der Substrathalter zueinander.

In einem **fünften** erfindungsgemäßen Verfahrensschritt erfolgt eine Vermessung der Substrathalterrückseiten des ersten und/oder zweiten Substrats und falls nötig eine entsprechende Anpassung der ausbreitenden Bondwellenfront durch entsprechende Schaltung der Fixierelemente der einzelnen Zonen.

Der Abstand zwischen den sich angenäherten Substraten liegt zwischen 0µm und 2000µm, vorzugsweise zwischen 0µm und 1500µm, noch bevorzugter zwischen 0µm und 1000µ, am allerbevorzugtesten zwischen 0µm und 500µm.

Weitere Vorteile, Merkmale und Einzelheiten der Erfindung ergeben sich aus der nachfolgenden Beschreibung bevorzugter Ausführungsbeispiele sowie anhand der Zeichnungen. Diese zeigen in:
- Figur 1:: ein erfindungsgemäßer Substrathalter in einer ersten erfindungsgemäßen Ausführungsform,
- Figur 2:: ein erfindungsgemäßer Substrathalter in einer zweiten erfindungsgemäßen Ausführungsform,
- Figur 3:: ein erfindungsgemäßer Substrathalter in einer dritten erfindungsgemäßen Ausführungsform,
- Figur 4:: ein erfindungsgemäßer, vereinfacht dargestellter Substrathalter in einer vierten erfindungsgemäßen Ausführungsform,
- Figur 5:: ein erfindungsgemäßer, vereinfacht dargestellter Substrathalter in einer fünfter erfindungsgemäßen Ausführungsform,
- Figur 6:: ein erfindungsgemäßer, vereinfacht dargestellter Substrathalter in einer sechster erfindungsgemäßen Ausführungsform und
- Figur 7:: ein erfindungsgemäßer, vereinfacht dargestellter Substrathalter gemäß Fig. 4 mit einem fixierten Substrat.

In den Figuren sind gleiche Bauteile oder Bauteile mit der gleichen Funktion mit den gleichen Bezugszeichen gekennzeichnet.

Alle dargestellten Figuren sind schematische, nicht notwendigerweise maßstabsgetreue Darstellungen der Substratoberflächen mit ihren Zonen und Fixierelementen. Auf die komplette Darstellung der Substrathalte mit allen Bauteilen wird absichtlich verzichtet, da sie keinen Mehrwert für die erfindungsgemäße Idee haben. Insbesondere werden die ersten drei erfindungsgemäßen Substrathalter genauer dargestellt als die letzten drei Substrathalter.

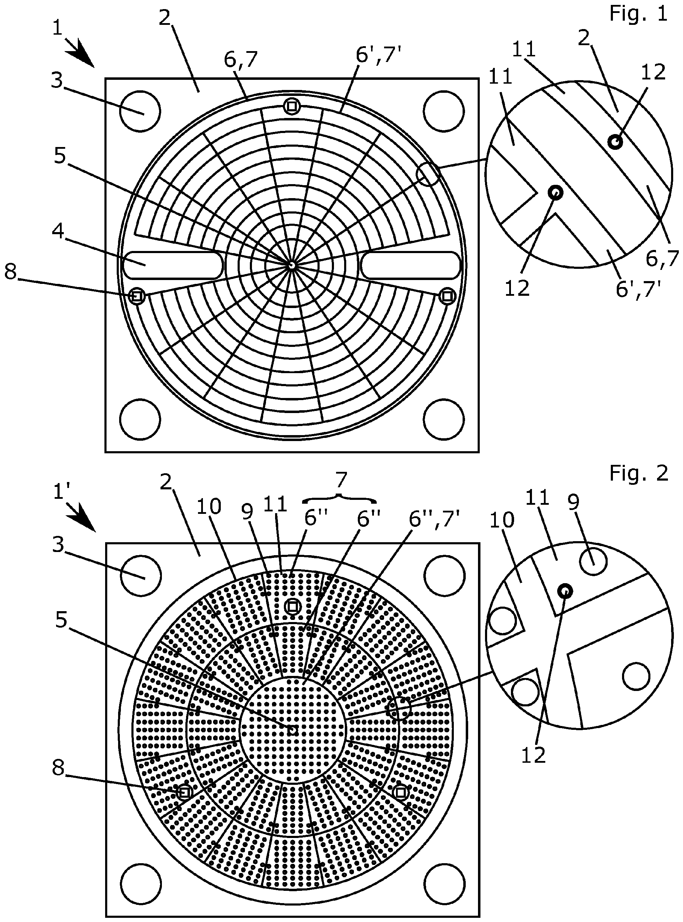

Die **Figur 1** zeigt die Fixieroberfläche eines erfindungsgemäßen Substrathalters 1 in einer ersten erfindungsgemäßen beispielhaften Ausführungsform. Der Substrathalter 1 weist einen Grundkörper 2 auf, insbesondere eine Platte. Der Grundkörper 2 kann mit Befestigungen 3 an einer Vorrichtung montiert werden. Im Grundkörper 2 befinden sich im Fixierbereich zwei Aussparungen 4, insbesondere Langlöcher, durch welche die Rückseite eines Substrats (nicht eingezeichnet) beobachtet werden kann.

Im Zentrum des Substrathalters 1 befindet sich ein Verformelement 5, insbesondere ein Stift oder eine Düse. Der Substrathalter verfügt über zwei, insbesondere unterschiedlich ausgeführte erfindungsgemäße Fixierelemente 6, 6'. Das äußere Fixierelement 6 ist insbesondere vollumfänglich und kreisförmig konstruiert. Bei den Fixierelementen 6, 6" handelt sich insbesondere um sehr dünn ausgeführte Vertiefungen 11, die vorzugsweise über eine Fluidöffnung 12 evakuiert werden können und damit als Vakuumfixierelement wirken.

Das innere Fixierelement 6' wird als Netzwerk von Vertiefungen 11 über die restliche Fläche des Grundkörpers 2 ausgeführt. Das Fixierelement 6' wird insbesondere ebenfalls als Vakuumfixierelement ausgeführt. Das äußere Fixierelement 6 ist damit das einzige einer Zone 7 zugehörige Fixierelement. Das innere Fixierelement 6' ist das einzige einer Zone 7' zugehörige Fixierelement. Der Substrathalter 1 kann noch über unterschiedliche Sensoren 8, insbesondere Druckmesssensoren verfügen.

Die Zonen 7,7' sind in allen dargestellten Ausführungsformen ringförmig, insbesondere kreisringförmig, angeordnet.

Die Anzahl der in den folgenden Figuren dargestellten Stifte 9 ist in den Figuren viel geringer als in einem realen Substrathalter. Ein erfindungsgemäßer Substrathalter kann hunderte, wenn nicht sogar tausende solcher Stifte 9 pro Fixierelement 6" besitzen.

Die **Figur 2** zeigt die Fixieroberfläche eines erfindungsgemäßen Substrathalter 1' in einer zweiten erfindungsgemäßen Ausführungsform. Der Grundkörper 2 kann mit Befestigungen 3 an einer Vorrichtung montiert werden. Der Substrathalter 1' verfügt über mehrere, insbesondere radial und azimutal abgegrenzte Fixierelemente 6".

Bei den Fixierelementen 6" handelt es sich insbesondere um zurückgesetzte, vorzugsweise ausgefräste, Vertiefungen 11, in denen sich an einigen Stellen Stifte 9 (engl.: pins) befinden. Die Stiftoberfläche der Stifte 9 ist insbesondere kongruent zur Stegoberfläche der Stege 10. Die Fixierelemente 6" sind insbesondere als Vakuumfixierelemente ausgeführt. Die Vertiefungen 11 können, insbesondere einzeln und durch die Trennung durch die Stege 10 unabhängig voneinander, über einen Fluidausgang 12 evakuiert werden. Sollten die Fixierelemente 6" auch als Verformelemente dienen, kann über die Fluidöffnung 12 auch ein Fluid einströmen, welches zu einer, insbesondere lokalen Verformung eines Fixierten Substrats führt.

Mehrere Fixierelemente 6" sind zu einer Zone 7 zusammengefasst, während ein weiteres, anders geformtes, zentrisches Fixierelement 6" eine zweite, zentrische Zone 7' bildet. Im Zentrum des Substrathalters 1' befindet sich vorzugsweise ein Verformelement 5, das ein fixiertes Substrat, insbesondere zentrisch, verformen kann. Die Stifte 9 dienen insbesondere der Reduktion der Kontaktfläche eines fixierten Substrats, vorzugsweise um Kontamination zu vermeiden. Mehrere Sensoren 8, insbesondere Drucksensoren, können über die Fixierfläche des Substrathalters 1' verteilt sein.

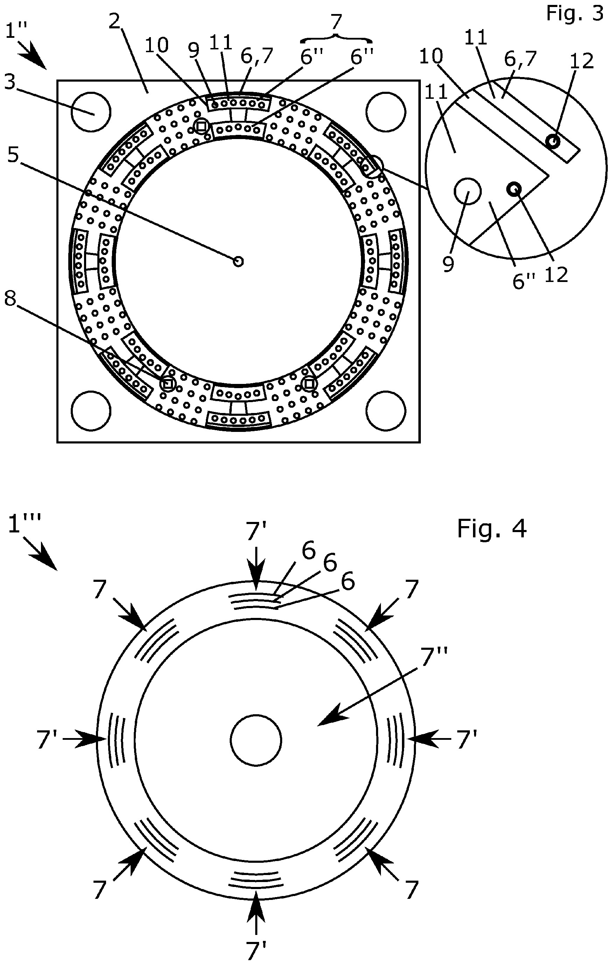

Die **Figur 3** zeigt eine weitere, noch vorteilhaftere erfindungsgemäße Ausführungsform eines erfindungsgemäßen Substrathalters 1". Die Fixierelemente 6, 6" befinden sich in der Peripherie des Substrathalters 1" und sind azimutal voneinander getrennt. Das Fixierelement 6 ist insbesondere eine einfache Vertiefung 11, eine Nut, die wieder sehr dünn ausgeführt wurde, während die Fixierelemente 6" wieder als Vertiefungen 11, mit Stiften 9 und Fluidausgängen 12 konstruiert wurden. Zwischen den Fixierelementen 6, 6" können sich Bereiche mit Vertiefungen 11 mit Stiften 9 befinden. Diese Bereiche können auch, müssen aber nicht, als Fixierelemente konstruiert sein. Ebenso kann der zentrische Bereich entweder ausschließlich als Vertiefung 11 mit Stiften 9 konstruiert sein und/oder wiederum als Fixierelement dienen. Denkbar wäre auch, dass der zentrische Bereich eine ebene Oberfläche besitzt, wie in der Figur dargestellt. Diese Darstellung wurde in diesem Fall gewählt um den Fokus auf die Fixierelemente 6, 6" in der Peripherie zu legen und sie besser hervorzuheben. Der Substrathalters 1" kann wiederum über Sensoren 8 und/oder ein Verformelement 5 verfügen. Insbesondere können auch die einzelnen Fixierelemente 6, 6" wieder als Fixier- und/oder Verformelement dienen.

Alle gezeigten erfindungsgemäßen Ausführungsformen sollen das Konzept mehrerer Fixierelemente 6, 6', 6" offenbaren, die zu Zonen 7,7' gruppiert werden können. Das Konzept der Zonenbildung geht aber weit über die Gruppierung der einzelnen Fixierelemente, die einander benachbart sind, hinaus. Erfindungsgemäß ist es nämlich möglich, Fixierelemente, die einander nicht benachbart sind, zu Zonen zu gruppieren. Um diesen erfindungsgemäßen Aspekt zu verdeutlichen wird in den weiteren Figuren darauf verzichtet, die Substrathalter mit allen Einzelheiten abzubilden. Viel mehr werden nur die Fixierelemente mit Hilfe der Bezugszeichen 6, 6', 6" und die Zonen mit Hilfe der Bezugszeichen 7, 7', 7", 7'" bezeichnet.

Die dargestellten, azimutal voneinander getrennten, Zonen haben einen Kreissegmentwinkel zwischen 5° und 90°, vorzugsweise zwischen 10° und 70°, noch bevorzugter zwischen 20° und 50°, am bevorzugtesten zwischen 22° und 30°, am allerbevorzugteste von ca. 22.5°.

Die Zonen besitzen eine radiale Länge zwischen 50mm und 1mm, vorzugsweise zwischen 50mm und 10mm, noch bevorzugter zwischen 50mm und 20mm, am bevorzugtesten zwischen 50mm und 30mm, am allerbevorzugtesten zwischen 50mm und 40mm.

Die **Figur 4** zeigt eine weitere, spezielle Ausführungsform eines erfindungsgemäßen Substrathalters, bei dem es drei unterschiedliche Zonen gibt. Die erste Zone 7, besteht aus insgesamt 12 Fixierelementen 6, die sich in Gruppen zu jeweils drei Fixierelementen 6 in der Diagonale befinden. Die zweite Zone 7', besteht aus insgesamt 12 Fixierelementen 6, die sich in Gruppen zu jeweils drei Fixierelementen 6 an der linken, der rechten, der oberen und der unteren Seite des erfindungsgemäßen Substrathalters befinden. Im Zentrum befindet sich noch eine große Zone 7", die insbesondere nur aus einem einzigen Fixierelement 6 besteht.

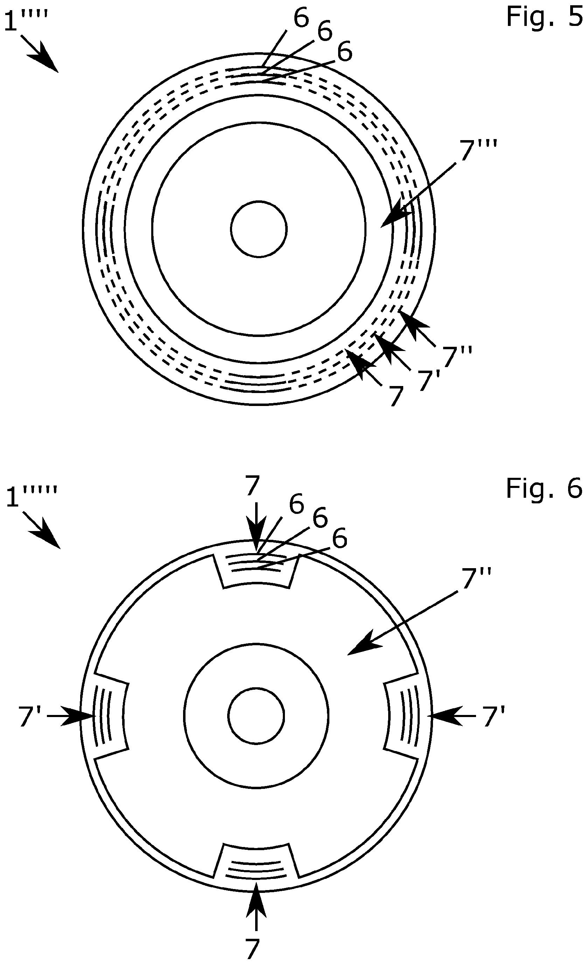

Die **Figur 5** zeigt eine weitere, spezielle Ausführungsform eines erfindungsgemäßen Substrathalters, bei dem es vier unterschiedliche Zonen 7, 7', 7", 7'" gibt. Die erste, äußerste Zone besteht aus vier Fixierelementen 6, die entlang eines Kreises positioniert sind. Analog gilt dasselbe für die Zonen 7' und 7", die sich bei einem jeweils kleineren Radius befinden. Die vierte Zone 7'" ist eine größere, insbesondere vollumfänglich geschlossene, insbesondere nur aus einem Fixierelement 6 bestehende, Zone bei noch kleinerem Radius.

Die **Figur 6** zeigt eine weitere, spezielle Ausführungsform eines erfindungsgemäßen Substrathalters, bei dem es drei unterschiedliche Zonen 7, 7', 7" gibt. Die erste Zone 7 besteht aus sechs Fixierelementen 6. Die Fixierelemente 6 befinden sich in zwei Gruppen zu jeweils drei Fixierelementen an der oberen und unteren Position. Die zweite Zone 7' besteht aus sechs Fixierelementen 6. Die Fixierelemente 6 befinden sich in zwei Gruppen zu jeweils drei Fixierelementen an der linken und rechten Position. Eine weitere, großflächige, insbesondere nur aus einem Fixierelement 6 bestehende, Zone 7" füllt einen Großteil der restlichen Fläche aus und umschließt die beiden Zonen 7, 7' sogar teilweise.

Aus den gezeigten Figuren soll das Konzept hervorgehen, dass man jede Menge von Fixierelementen 6, zu beliebigen Zonen zusammenschließen kann. In den weiteren Figuren wird nun erklärt, wozu diese Zonenbildung notwendig ist.

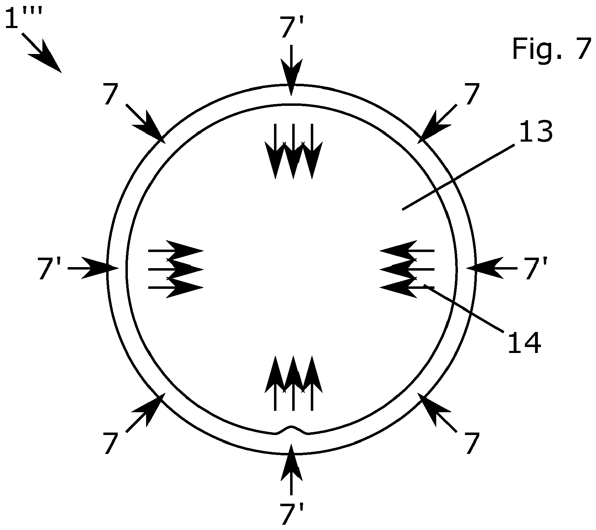

Die **Figur 7** zeigt exemplarisch den erfindungsgemäßen Substrathalter 1'" aus der Figur 4. Der Substrathalter 1'" fixiert nun allerdings ein Substrat 13, welches die Fixierelemente 6 verdeckt. Die Position der Zonen 7, 7' wird dennoch angezeigt. Die Pfeile 14 symbolisieren eine mechanische Anisotropie, die es mit Hilfe der erfindungsgemäßen Zonen 7, 7', 7" zu kompensieren gilt und zwar vor und/oder während eines Bondvorgangs. Das dargestellte Substrat 13 könnte beispielsweise eine von der Richtung abhängigen E-Modul besitzen, so wie das für kubische Materialien innerhalb der kristallographischen (100) Ebene der Fall ist. Dadurch würde eine an sich homogen angreifende Kraft wie die Schwerkraft, die zu einem Durchhängen des Substrats 13 führt zu einer anisotropen Dehnung innerhalb des Substrats führen. Denkbar wäre auch, dass durch eine Fixierung des Substrats ausschließlich durch die Zone 7' eine Verzerrung eintritt, die dann auch als mechanische Anisotropie bezeichnet werden würde. Diese wäre vielleicht durch das zusätzliche Schalten der Zone 7" (verdeckt durch das Substrat 13) kompensierbar. Die korrekte Schaltung der einzelnen Zonen zur optimalen und gewünschten Kompensation der mechanischen Anisotropie 14 wird idealerweise durch Versuche ermittelt. Es wird noch erwähnt, dass die einzelnen Fixierelemente 6 einer Zone, insbesondere so konstruiert sein können, dass sie radial angeordnet sind. Diese Anordnung erlaubt insbesondere eine radiale Anpassung, während die Bondwelle sich vom Zentrum zum Rand bewegt.

### Bezugszeichenliste

- 1,1',1",1‴,1ʺʺ,1‴ʺ: Substrathalter
- 2: Grundkörper
- 3: Befestigungen
- 4: Aussparung
- 5: Verformelement
- 6, 6', 6": Fixierelement
- 7, 7': Zone
- 8: Sensor
- 9: Stift
- 10: Steg
- 11: Vertiefung
- 12: Fluidausgang, insbesondere Bohrung
- 13: Substrat
- 14: Mechanische Anisotropie

## Patentansprüche

1. Substrathalter (1,1',1",1‴,1ʺʺ,1‴ʺ) zur Aufnahme eines Substrats (13), aufweisend Fixierelemente (6,6',6") zur Fixierung des Substrats (13), wobei die Fixierelemente (6,6`,6") in Zonen (7, 7') gruppierbar sind, wobei die Zonen (7, 7') vorzugsweise ringförmig, bevorzugter kreisringförmig, angeordnet sind, wobei der Substrathalter (1,1',1",1‴,1ʺʺ,1‴ʺ) Sensoren (8) zur Überwachung eines Abstandes zwischen dem Substrat (13) und dem Substrathalter (1,1',1",1"',1"",1""') aufweist.

2. Substrathalter (1,1',1",1"',1"",1""') nach Anspruch 1, wobei die Zonen (7, 7') symmetrisch zum Zentrum des Substrathalters (1,1',1",1"',1"",1""') angeordnet sind.

3. Substrathalter (1,1',1",1‴,1ʺʺ,1‴ʺ) nach mindestens einem der vorhergehenden Ansprüche, wobei die Zonen (7, 7') in mehreren Ringen, bevorzugt Kreisringen, um das Zentrum des Substrathalters (1,1',1",1‴,1ʺʺ,1‴ʺ) herum angeordnet sind.

4. Substrathalter (1,1',1",1‴,1ʺ,1‴ʺ) nach mindestens einem der vorhergehenden Ansprüche, wobei die Zonen (7, 7') in radialer Richtung und/oder in azimutaler Richtung gleichmäßig voneinander beabstandet sind.

5. Substrathalter (1,1',1",1‴,1ʺ,1‴ʺ) nach mindestens einem der vorhergehenden Ansprüche,, wobei die Zonen (7, 7') vom Zentrum des Substrathalters (1,1',1",1"',1"",1""') zum Rand des Substrathalters (1,1',1",1"',1"",1""') hin mit sich ändernder Breite, insbesondere mit größer werdender Breite, ausgebildet sind.

6. Substrathalter (1,1',1",1‴,1ʺʺ,1‴ʺ) nach mindestens einem der vorhergehenden Ansprüche, wobei die Zonen (7, 7') einzeln schaltbar sind.

7. Substrathalter (1,1',1",1‴,1ʺʺ,1‴ʺ) nach mindestens einem der vorhergehenden Ansprüche, wobei mehrere Zonen (7, 7') gruppierbar und gemeinsam schaltbar sind.

8. Substrathalter (1,1',1",1‴,1ʺʺ,1‴ʺ) nach mindestens einem der vorhergehenden Ansprüche, wobei die Anzahl der Fixierelemente (6,6`,6") in den Zonen (7, 7') flexibel veränderbar ist.

9. Substrathalter (1,1',1",1‴,1ʺʺ,1‴ʺ) nach mindestens einem der vorhergehenden Ansprüche, wobei die Fixierelemente (6, 6') flexibel verschiedenen Zonen (7, 7') zugeordnet werden können.

10. Substrathalter (1,1',1",1‴,1ʺʺ,1‴ʺ) nach mindestens einem der vorhergehenden Ansprüche, wobei die Fixierelemente (6, 6') zonenübergreifend ansteuerbar sind.

11. Substrathalter (1,1',1",1‴,1ʺʺ,1‴ʺ) nach mindestens einem der vorhergehenden Ansprüche, wobei mit den Sensoren (8) eine Ausbreitungsgeschwindigkeit und eine, insbesondere symmetrische, Form einer Bondwelle während eines Bondprozesses überwachbar ist und insbesondere adaptiv anpassbar ist.

12. Verfahren zur Fixierung und zum Bonden eines Substrats (13) oder mehrerer Substrate mit einem Substrathalter (1,1',1",1‴,1ʺʺ,1‴ʺ) gemäß mindestens einem der vorhergehenden Ansprüche, wobei Fixierelemente (6,6',6") in Zonen (7, 7') gruppiert werden, wobei die Zonen (7, 7') bevorzugt ringförmig, bevorzugter kreisringförmig, ausgebildet werden.

13. Verfahren nach Anspruch 12, wobei die Zonen (7, 7') einzeln geschaltet werden.

14. Verfahren nach mindestens einem der vorhergehenden Ansprüche, wobei mehrere Zonen (7, 7') gruppiert und gemeinsam geschaltet werden.

15. Verfahren nach mindestens einem der vorhergehenden Ansprüche, wobei die Anzahl der Fixierelemente (6,6`,6") in den Zonen (7, 7') flexibel verändert wird.

16. Verfahren nach mindestens einem der vorhergehenden Ansprüche, wobei die Fixierelemente (6, 6') flexibel verschiedenen Zonen (7, 7') zugeordnet wird.
